# EUROPEAN PATENT APPLICATION

(11) **EP 1 049 249 A1**
(43) Date of publication of application: **02.11.2000**
(21) Application number: 99303445.3
(22) Date of filing: 30.04.1999
(51) Int. Cl.: H03G 1/00, H03F 1/32

(54) **Variable gain amplifiers**

(71) Applicant: LUCENT TECHNOLOGIES INC., Murray Hill, New Jersey 07974-0636 (US)
(72) Inventor: Rohani, Nader, Camberley, Surrey GU15 4RQ (GB)
(74) Representative: Williams, David John

(57) **Abstract**

A variable gain amplifier is described having two parallel amplifying paths driving a common load RL. One path defined by the transistor (Q3) and including a relatively low impedance (L1) provides a high gain/low linearly amplification. The other path defined by the transistor (Q6) by using a relatively high impedance (L2) provides a low gain high linearly amplification. Current generators (I1 and I3) control the DC bias supplied to the bases of respective transistors (Q2 and Q6). By adjusting the two current generators (I1 and I3) in opposite senses, the ratio of the impact that each transistor (Q3 and Q6) has on the load RL can be varied.

The provision of mirror image amplifiers using transistors (Q3 and Q7) which share the impedances (L1 and L2) with respective transistors (Q2 and Q6) enables the input and output impedances of the amplifier to remain substantially constant irrespective of the gain being achieved.

## Description

### Background of the Invention

### Field of the Invention

Most radio transmitters and receivers use amplifiers having automatic gain control using variable gain amplifiers.

### Description of the Prior Art

In radio transmitters, the automatic gain control is used to control the output power and the linearity of the input/output characteristic. In a radio receiver, the gain control is used to allow the receiver to handle a wide dynamic range of signals. In both cases, the object is to process the radio frequency signal as substantially linear manner as possible to reduce signal distortion.

Mobile telephone systems employ an array of base stations situated in a region where mobile telephone units are operating. When a particular mobile unit approaches a particular base station, the received signal strength at the base progressively increases in strength. There is therefore a requirement for automatic gain control at the front end of the radio frequency amplifying chain of the base station in order to reduce the signal level travelling to successive amplifying stages of the chain. This prevents the signals operating in a non-linear region of each amplifying stage.

However, the automatic control system itself has no protection again large signals which reach it and such signals may be processed non-linearly or even cause saturation. These defects would then be magnified at each successive amplification stage.

A solution to such problems would be to use a pin diode as a gain control element which would act as a variable resistor in front of an amplifier.

Such a solution would not increase the linearity of the amplifier itself in the presence of strong signals and does not lend itself to use integrated circuit situations without the use of external components often requiring their own bias voltage and additional circuitry. Such solutions are also subject to increased noise levels.

It is an object of the invention to provide an improved variable gain amplifier.

### Summary of the Invention

According to the present invention there is provided a variable gain amplifier comprising a common load, a first amplifying transistor driving said local and having an emitter/collector path connected in circuit series with a first relatively low impedance, a second amplifying transistor also driving said load and having an emitter/collector path connected in circuit series with a second relatively high impedance, input means supplying the base of each of said first and second amplifying transistors with an input signal to be amplified, and control means for varying the DC bias to the bases of said first and second transistor amplifiers to vary the ratio of the extent to which each transistor drives the load whereby to vary the performance of the amplifier progressively between a low gain high linearly and a high gain low linearly.

According to the present invention there is further provided an automatic gain control amplifier having a relatively high minimum gain amplifying element and a relatively low maximum gain amplifying element both connected to receive a common input signal and both driving a common load, means for monitoring the amplitude of the output signal envelope appearing across the load to reduce the gain of the high gain element and to increase the gain of the low gain element when the said amplitude tends to increase and vice versa when the said amplitude tends to reduce, both in a sense to maintain the amplitude of the output signal envelope substantially constant.

### Brief Description of the Drawings

A gain control amplifier embodying the present invention will now be described, by way of example, with reference to the accompanying drawings, in which:
Figure 1 is a block diagram of a base station receiver;
Figure 2 is a circuit diagram of the amplifier;
Figure 3 is a block diagram of an automatic gain control circuit incorporating the amplifier of Figure 2; and
Figure 4 is a block diagram of a balanced automatic gain control circuit.

### Detailed Description of the Invention

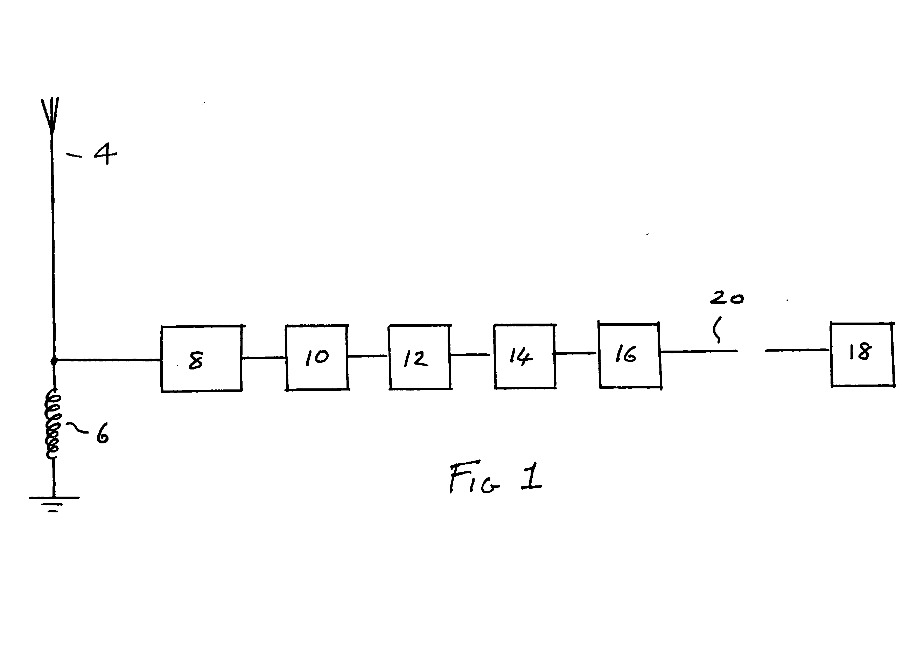

As shown in Figure 1, an antenna 4 is coupled to earth via an impedance 6. The junction between the antenna and the impedance 6 feeds an automatic gain control amplifier 8 which in turn feeds an RF (radio frequency) amplifier 10. The output of the RF amplifier 10 is fed to a mixer 12 to select a signal of the desired frequency, which signal is in turn demodulated by a demodulator 14 to produce an audio frequency signal. The audio frequency signal is amplified by an AF (audio frequency) amplifier 16 and transmitted down a land line 20 to a local telephone exchange 18.

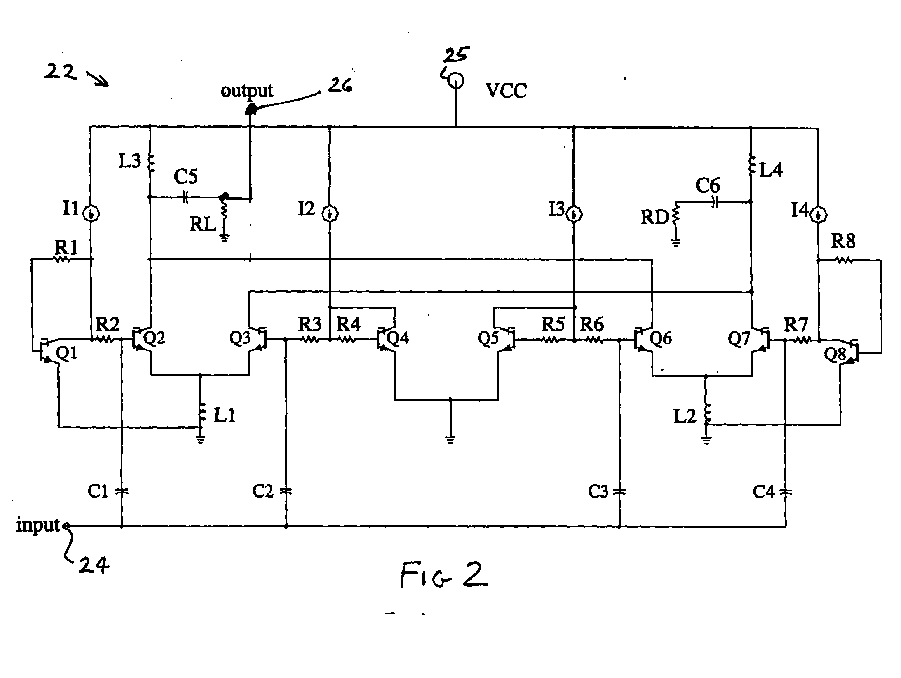

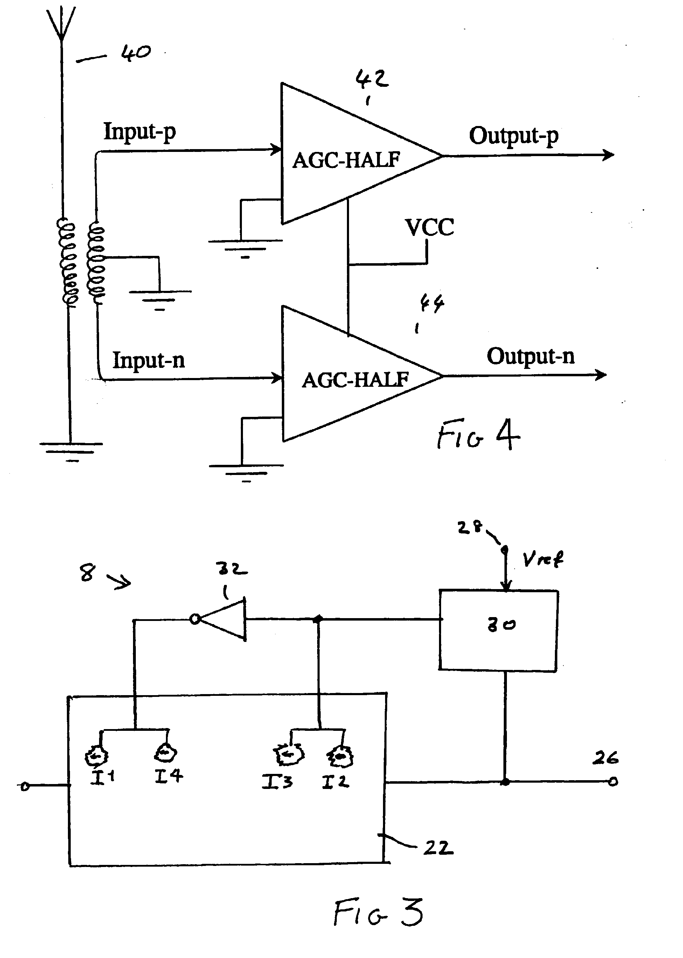

The automatic gain control amplifier 8 (see Figure 3) employs a variable gain amplifier 22, the circuit of which is more clearly seen in Figure 2.

As shown in Figure 2, the amplifier 22 has an input 24 for receiving an input signal from the antenna 4 and an output for feeding the input of the RF amplifier 10.

The input signal is amplified in parallel by two transistors Q2 and Q6 which are matched to a common load RL via matching impedance C5, L3. Coupling capacitors C1 and C2 couple the input signal to the bases of respective transistors Q2 and Q6. The collector/ emitter path of the transistor Q2 is connected in circuit series with a relatively low value impedance L1 (in this case an inductance). An impedance L3 couples the collector to transistor Q2 to a voltage bus 25. This allows a relatively large amplification of the input signal (when the received signal has a relatively low value) but this also means that the linearity of the amplified signal is also relatively low.

Impedance L4 and C6 are identical to C5 and L3 ensuring that the same impedance values are present at the collectors of Q3 and Q7 as with Q2 and Q6, hence maintaining circuit balance. The collector or emitter path of the transistor Q6 is connected in circuit series with a relatively high value impedance L2 (in this case an inductor). This prevents a relatively high amplification of the input signal (especially when the received input signal has a relatively high value) but also has the desirable result that the linearity of the amplified signal is particularly high.

The base bias of the two transistors Q2 and Q6 is controlled to switch the transistor Q2 progressively ON and to switch transistor Q6 progressively OFF in response to a falling amplitude of the input signal envelope and to switch the transistor Q2 progressively OFF and the transistor Q6 progressively ON in response to a rising amplitude of the input signal envelope. For a maximum amplitude input signal, the transistor Q6 is turned fully ON while for minimum amplitude input signal the transistor Q2 is turned fully ON.

The DC basis for transistor Q2 is controlled by a constant current source I1 which is connected in circuit series with the collector/emitter path of a transistor Q1 to ground. The DC bias for the transistor Q1 is provided by a resistor R1 coupled between the base and the collector of transistor Q1. The DC bias for the transistor Q2 is provided by a resistor R2 coupled between the collector of transistor Q1 and the base of transistor Q2. The arrangement is such that DC current flowing through the collector/emitter path of transistor Q2 essentially mirrors the current provided by the current generator I1. If greater current is required to flow through the impedance L1, one or more further transistors can be used in parallel with transistor Q2. Namely, the collector/emitter paths of such transistors are connected in parallel with the collector/emitter path of transistor Q2 and the bus of such further transistors are coupled to the base of Q2.

The DC bias for the transistor Q6 is provided by an arrangement similar to that used for transistor Q2. Thus, a constant current source I3 is coupled by the emitter/collector path of transistor Q5 to ground and resistors R5 and R6 respectively connect the collector to transistor Q5 to the base of transistor Q5 and the base of transistor Q6.

The problem with the amplification performed by transistor Q2 and its biasing arrangement and the amplification performed by transistor Q6 and its biasing arrangement is that, as the DC biases vary for different gains to be achieved so also do the input impedance and the output impedance of the amplifier when viewed from input terminal 24 and output terminal 26, respectively.

Therefore, to maintain the current flows in L1 and L2 substantially constant, mirror amplifiers based on transistors Q3 and Q7 are employed to share the impedances L1 and L2.

Coupling capacitors C2 and C4 couple the input signal to the bases of respective transistors Q3 and Q7. The transistors Q3 and Q7 are coupled via a coupling capacitor C6 to a dummy load RD having the same value as the load RL. The emitter/collector path of transistor Q3 connected in circuit series with the impedance L1.

The DC bias for the base of transistor Q3 is provided by a constant current device I2 which is connected to ground through the emitter/collector path of a transistor Q4 and bias resistors R3 and R4 respectively couple the collector of transistor Q4 to the bases of transistors Q3 and Q4.

The constant current sources I2 and I3 are operated in tandem so that the current generated by both is the same at any instant.

In a similar manner, the emitter/collector path of the transistor Q7 is connected in circuit series with the impedance L2 and the DC bias for the transistor Q7 is provided by a constant current source I4. The emitter/collector path of a transistor Q8 connects the constant current source to ground while bias resistors R7 and R8 connect the collector of transistor Q8 to the bases of respective transistors Q7 and Q8.

Again as before, the current sources I4 and I1 are operated in tandem so that at any instant the current generated by each will remain the same.

As far as the relative values of L2 and L1 are concerned, they advantageously lie within a ratio of from 2:1 to 20:1. In a typical example, L2 = 10 nH while L2 = 2.5 nH ie 4:1. Such an arrangement would allow a change in gain ratio from 4 dB to 12 dB.

The incorporation of the variable gain circuit (having constant input and output impedances and the resultant beneficial gain/linearly characteristic described), in an automatic gain control circuit, is shown more clearly in Figure 3. As shown, a comparator 30 has one input connected to the output 26 of the amplifier 22 and another output connected to a terminal 28 supplied by a reference voltage V_{ref} representing a desired gain. The output of the comparator 30 is fed to control the current sources I3 and I2 of the amplifier 22 directly and via an inverting amplifier 32 to control the current sources I1 and I4. Thus, the current sources I1 and I4 are controlled in inverse ratio to the current sources I2 and I3.

When the variable gain amplifier is embedded in an integrated circuit further noise reduction in the circuit can be achieved by using two amplifiers each as herein described forming two halves of a split system.

Such a system is shown in Figure 4, where two input signals of opposite polarity or phase are derived from a signal received by an antenna and input into two amplifiers 42 and 44 which in turn produce positive and negative output signals.

It will be appreciated that while the preferred embodiment describes the variable gain amplifier being used in a radio receiver, it can also be used in a radio transmitter. Nor is the use of the amplifier limited to the field of radio communication but, as will be appreciated, it can be used in any electrical environment which requires a variable gain giving the described gain/linearly characteristics.

Changes may be made in the combination and arrangement of the elements as herein before set forth in the specification and shown in the drawings, it being understood that changes may be made in the embodiment disclosed without departing from the spirit and scope of the invention and defined in the following claims.

## Claims

1. A variable gain amplifier comprising a common load, a first amplifying transistor driving said local and having an emitter/collector path connected in circuit series with a first relatively low impedance, a second amplifying transistor also driving said load and having an emitter/collector path connected in circuit series with a second relatively high impedance, input means supplying the base of each of said first and second amplifying transistors with an input signal to be amplified, and control means for varying the DC bias to the bases of said first and second transistor amplifiers to vary the ratio of the extent to which each transistor drives the load whereby to vary the performance of the amplifier progressively between a low gain high linearly and a high gain low linearly.

2. An amplifier according to Claim 1, comprising a common dummy load, a third amplifying transistor driving said dummy load and having an emitter/collector path connected in circuit series with the first impedance, a fourth amplifying transistor driving said dummy load and having an emitter/collector path connected in circuit series with the second impedance, wherein said input means supplies said input signal to the bases of said third and fourth amplifying transistors and said control means varies the DC bias to the bases of said third and fourth amplifying transistors to vary the ratio of the signal amplification that each supplies to the dummy load whereby, to maintain the current drawn by each said first and second impedance constant, irrespective of any variation of said ratio, whereby to maintain the input and output impedances of the amplifier substantially constant irrespective of the gain setting of the amplifier.

3. An amplifier according to Claim 2, wherein the control means comprises first and second constant current sources adjustable in tandem, said first current source supplying a DC bias to the base of the first amplifier transistor and the second constant current source supplying a DC bias to the base of the fourth amplifying transistor, third and fourth constant current sources adjustable in tandem, said third source supplying a DC bias to the base of said third amplifying transistor and said fourth source supplying a DC bias to the base of said fourth amplifier transistor, and means for varying said first and second current sources and said third and fourth current sources in inverse proportion so that when the output of said first and second current sources is a minimum, the output of said third and fourth current sources is a maximum and vice versa.

4. An automatic gain control amplifier comprising a variable gain amplifier according to any preceding claim, a comparator having a first input connected to receive the output signal from the variable gain amplifier and a second input for receiving a reference signal, the output of the comparator being connected to control the first and fourth constant current sources, and through an inverter to control the third and fourth constant current sources in a manner so as to maintain the amplification of the signal envelope of the output signal substantially constant.

5. An automatic gain control amplifier having a relatively high minimum gain amplifying element and a relatively low maximum gain amplifying element both connected to receive a common input signal and both driving a common load, means for monitoring the amplitude of the output signal envelope appearing across the load to reduce the gain of the high gain element and to increase the gain of the low gain element when the said amplitude tends to increase and vice versa when the said amplitude tends to reduce, both in a sense to maintain the amplitude of the output signal envelope substantially constant.

6. An automatic gain control system comprising two gain control amplifiers each according to Claim 5 and both supplied by a common power source, the inputs being arranged to receive the same signal but with two opposite sources and the outputs providing the same output signals but of opposite sense whereby to reduce noise levels therein.

7. A radio receiver including an antenna and a series of amplifier stages having an amplifier according to any preceding claim as the first amplification stage.
